(19) Europäisches Patentamt
European Patent Office
Office européen des brevets

(11) **EP 4 679 115 A1**

(12) **EUROPEAN PATENT APPLICATION**
published in accordance with Art. 153(4) EPC

(43) Date of publication:
**14.01.2026 Bulletin 2026/03**

(21) Application number: **24770613.8**

(22) Date of filing: **04.03.2024**

(51) International Patent Classification (IPC):
*G01R 31/392* (2019.01)   *G01R 31/367* (2019.01)
*H01M 10/48* (2006.01)   *H02J 7/00* (2026.01)

(52) Cooperative Patent Classification (CPC):
**G01R 31/367; G01R 31/392; G01R 31/396;
H01M 10/48; H02J 7/00;** Y02E 60/10

(86) International application number:
**PCT/JP2024/008073**

(87) International publication number:
**WO 2024/190502 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.03.2023 JP 2023037833**

(71) Applicants:
• **KRI, Inc.
Kyoto-shi, Kyoto 600-8813 (JP)**

• **Osaka Gas Co., Ltd.
Osaka-shi, Osaka 541-0046 (JP)**

(72) Inventors:
• **HAYANO, Akihito
Kyoto-shi, Kyoto 600-8813 (JP)**
• **MIZOGUCHI, Yasunori
Kyoto-shi, Kyoto 600-8813 (JP)**
• **KINOSHITA, Hajime
Kyoto-shi, Kyoto 600-8813 (JP)**

(74) Representative: **LBP Lemcke, Brommer & Partner
Patentanwälte mbB
Siegfried-Kühn-Straße 4
76135 Karlsruhe (DE)**

(54) **DETERMINATION DEVICE, DETERMINATION METHOD, AND DETERMINATION PROGRAM**

(57)     An object is to accurately determine the suitability of a secondary battery (battery) for an application, with a simple configuration. A determination apparatus determines, from a plurality of batteries 1, a battery 1 suitable for an application 4, and includes: an information acquisition unit 12 configured to acquire battery information 21 regarding the batteries 1; a degradation estimation unit 14 configured to estimate, for each of the batteries 1, per-cause degradation information 6 indicating a degradation state per degradation cause 7 from the battery information 21; an application input unit 15 configured to receive an input of the application 4; and a determination unit 17 configured to, based on the estimated per-cause degradation information 6 and the input application 4, determine a battery 1 suitable for the application 4 from the plurality of batteries 1 while considering a degree of influence of each degradation cause 7 on the application 4.

Fig.2

## Description

Technical Field

The present invention relates to a determination apparatus, a determination method, and a determination program for determining, from a plurality of batteries, a battery suitable for use.

Background Art

A secondary battery (battery) is installed and used in a variety of machines such as electric vehicles. Machines equipped with a secondary battery are used for various purposes. Here, the secondary battery degrades with use, and the cause and progress rate of degradation varies depending on the application (use conditions). When there are a plurality of such machines, the machine to be used may be selected based on the application of the machine and the degradation state of the secondary battery.

For example, the invention described in Patent Document 1 calculates a degradation tendency of a high voltage device (secondary battery) installed in a vehicle from a travel distance thereof, and uses a vehicle equipped with a high voltage device with a lower degradation tendency in a management environment where degradation is predicted to be greater.

Prior Art Document

Patent Documents

Patent Document 1: JP 2010-181986A

Disclosure of the Invention

Problem to be Solved by the Invention

However, with the conventional configuration, the degradation tendency is obtained only roughly, and it is difficult to obtain the degradation state with high accuracy. With the conventional configuration, vehicles with a lower degradation tendency are simply assigned to be used in a management environment where degradation is predicted to be greater, and it is possible that a suitable vehicle is not appropriately assigned to a scheduled management environment. Furthermore, it is also conceivable to predict a future degradation state due to use based on the application or the like, and select a secondary battery (machine) to be used in accordance with the application. However, it is difficult to predict the degradation state with a simple configuration or to predict it accurately.

To solve the foregoing issues, it is an object of the present invention to accurately determine the suitability of a secondary battery (battery) for a given application with a simple configuration.

Mans for Solving Probe

To achieve the above object, a characteristic configuration of a determination apparatus according to an embodiment of the present invention lies in a determination apparatus configured to determine, from a plurality of batteries, a battery suitable for an application, the determination apparatus including: an information acquisition unit configured to acquire battery information regarding the batteries; a degradation estimation unit configured to estimate, for each of the batteries, per-cause degradation information indicating a degradation state per degradation cause from the battery information; an application input unit configured to receive an input of the application; and a determination unit configured to, based on the estimated per-cause degradation information and the input application, determine a battery suitable for the application from the plurality of batteries while considering a degree of influence of each degradation cause on the application.

A characteristic configuration of a determination method according to an embodiment of the present invention lies in a determination method for determining, from a plurality of batteries, a battery suitable for an application, the determination method including: a step of acquiring battery information regarding the batteries; a step of estimating, for each of the batteries, per-cause degradation information indicating a degradation state per degradation cause from the battery information; a step of receiving an input of the application; and a step of, based on the estimated per-cause degradation information and the input application, determining a battery suitable for the application from the plurality of batteries while considering a degree of influence of each degradation cause on the application.

A characteristic configuration of a determination program according to an embodiment of the present invention lies in a determination program for determining, from a plurality of batteries, a battery suitable for an application, the determination program causing a computer to execute: a function of acquiring battery information regarding the batteries; a function of estimating, for each of the batteries, per-cause degradation information indicating a degradation state per degradation cause from the battery information; a function of receiving an input of the application; and a function of, based on the estimated per-cause degradation information and the input application, determining a battery suitable for the application from the plurality of batteries while considering a degree of influence of each degradation cause on the application.

A battery degrades due to various causes. A battery degrades due to different degradation causes depending on its use conditions, i.e., the application, and the degradation progresses at different rates depending on the application. Therefore, if the application and the per-cause degradation information indicating the degradation state per degradation cause of a battery are known, the degree of influence on the suitability of the battery for the application can be found.

According to the above configuration, the suitability of use of the battery can be determined for a given application without directly predicting the future degradation state of the battery, by estimating the per-cause degradation information for each battery. Thus, a battery suitable for the application can be accurately determined with a simple configuration.

The per-cause degradation information may include at least either a per-cause degradation state that is a degradation state per degradation cause, or a degradation rate that is a progress speed of degradation per degradation cause.

This configuration makes it possible to flexibly determine the degradation state of the battery in accordance with information regarding the battery that can be acquired, and to accurately determine a battery suitable for the application. Further, the degradation state of the battery can be more accurately determined by performing the determination using both the per-cause degradation state and the degradation rate, based on the current degradation state and degradation rate, and a battery suitable for the application can be determined accurately.

The per-cause degradation state may be calculated based on a prior per-cause degradation state that is the per-cause degradation state at a first time period back, and a unit per-cause degradation state indicating degradation during the first time period, while considering a time dependence that varies depending on the degradation cause and follows a power law for an elapsed time of the per-cause degradation state, and the degradation rate that varies depending on the degradation cause and is determined by the application.

This configuration makes it possible to more accurately obtain the per-cause degradation state, to more accurately determine the degradation state of the battery, and to accurately determine a battery suitable for the application.

The determination apparatus may further include a storage unit configured to store a ranking table generated for each application, wherein in the ranking table, ranking may be made in accordance with a value of the per-cause degradation information corresponding to each degradation cause, and the determination unit may reference the ranking table corresponding to the input application, rank each of the batteries based on the per-cause degradation information estimated for the battery, and determine a battery suitable for the application in accordance with the rank.

Ranking can be given in advance based on the degree of influence of the degradation state of the battery, according to the application in accordance with the application and the per-cause degradation information. According to this configuration, a battery suitable for the application can be determined easily and accurately by referring to the ranking table obtained by the ranking in advance.

The determination apparatus may further include a storage unit configured to store a determination condition generated for each application, wherein the determination condition may be such that a relationship between each degradation cause and a value obtained by applying a weight determined according to the degradation cause to the per-cause degradation information is defined by a condition, and ranking is made for each condition, and the determination unit may reference the determination condition corresponding to the input application, rank each of the batteries from the per-cause degradation information estimated for the battery, and determine a battery suitable for the application in accordance with the rank.

Ranking can be given by the determination conditions based on the degree of influence of the degradation state of the battery according to the application, in accordance with the application and the per-cause degradation information. According to this configuration, a battery suitable for the application can be determined easily and accurately by referring to the determination conditions ranked in advance.

One of the batteries may be installed in each of a plurality of electric vehicles, and the electric vehicle in which the battery selected in accordance with a result of determination by the determination unit is installed may be selected as the electric vehicle suitable for the application.

With this configuration, which electric vehicle is suitable for the application can be selected easily and accurately by selecting a battery suitable for the application.

The battery used for a predetermined first application may be reused as the battery to be used for a second application different from the first application in accordance with a result of determination by the determination unit.

Even if the battery used for a certain application has degraded, it can be reused for another application depending on the degradation state. For example, even if a battery installed in an electric vehicle has degraded, it can be reused as a stationary battery or a battery used for another specific application depending on the degradation state.

According to this configuration, it is possible to easily and accurately determine for which application the battery can be reused.

Brief Description of the Drawing

FIG. 1 shows an example of a concept of selecting an electric vehicle to be used from a plurality of electric vehicles in accordance with an application.
FIG. 2 shows an example of a configuration of a determination apparatus.
FIG. 3 shows an example of the flow of determining a battery.
FIG. 4 shows an example of a ranking table.
FIG. 5 shows an example of the ranking table with degradation rate considered.
FIG. 6 shows examples of determination conditions.

Best Mode for Carrying out the Invention

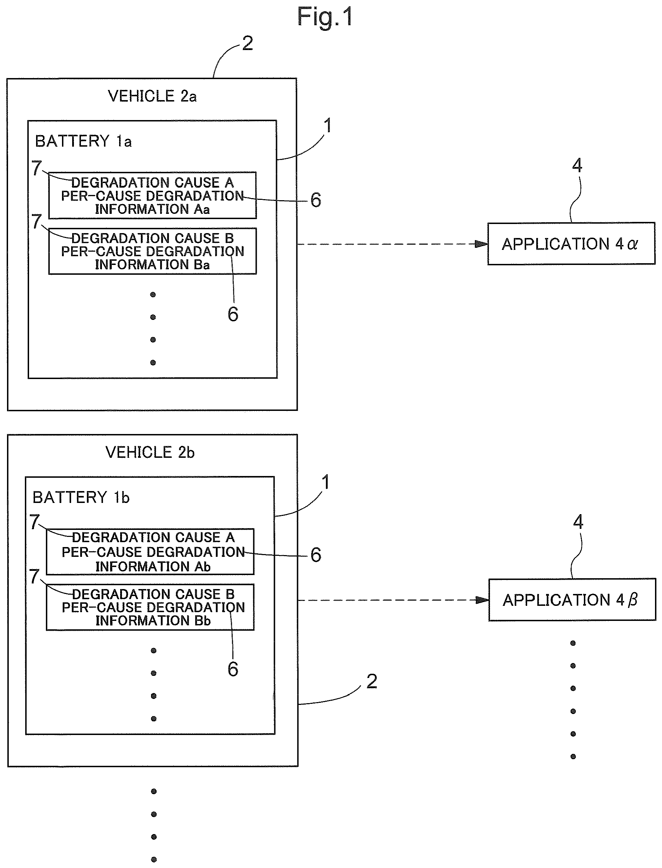

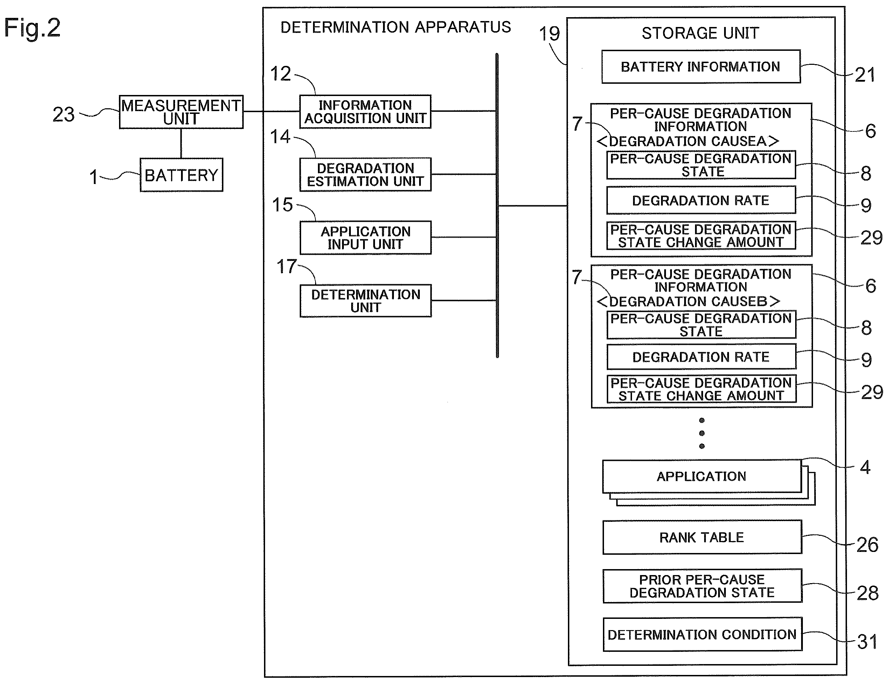

There are cases where an appropriate battery 1 is selected from a plurality of secondary batteries (hereinafter simply referred to as "batteries 1" (see FIG. 1)) in accordance with an application 4 (see FIG. 2). A determination apparatus according to an embodiment of the present invention estimates per-cause degradation information 6 (see FIG. 2), which indicates the degradation state per degradation cause 7 (see FIG. 1) of each battery 1, and determines, from a plurality of batteries 1, a battery 1 suitable for an application 4 while considering the degree of influence of the degradation cause 7 on the application 4.

Hereinafter, the determination apparatus will be described by taking as an example a configuration in which an electric vehicle 2 equipped with a battery 1 suitable for an application 4 is selected from a plurality of electric vehicles 2 each equipped with one battery 1 by determining a battery 1 suitable for the application 4. Here, "one battery 1" does not mean one cell but means a battery pack that includes a plurality of cells and functions as one battery 1 as a whole.

As shown in FIG. 1, a plurality of electric vehicles 2 equipped with batteries 1, including a vehicle 2a equipped with a battery 1a, a vehicle 2b equipped with a battery 1b, and so on, are prepared. The electric vehicles 2 are respectively assigned to the applications 4, which include an application $4\alpha$, an application $4\beta$, and so on. At this time, the per-cause degradation information 6 regarding each battery 1 is estimated, and a battery 1 suitable for an application 4 is determined out of the plurality of batteries 1 while considering the degree of influence of the degradation cause 7 on the application 4 with the per-cause degradation information 6. Then, an electric vehicle 2 equipped with the battery 1 corresponding to the determination result is selected as the electric vehicle 2 to be used for the application 4.

[Determination apparatus]

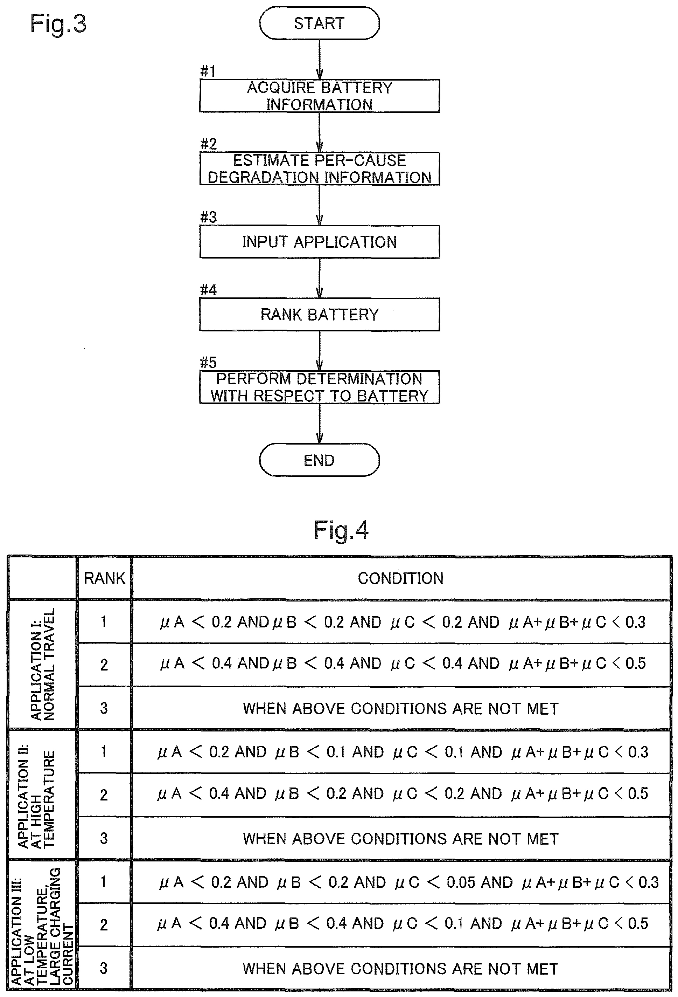

Next, an embodiment of the determination apparatus for determining the battery 1 will be described with reference to FIGS. 2 and 3.

The electric vehicle 2 is equipped with a secondary battery (battery 1) such as a lithium ion battery. Battery information 21, which includes various types of information regarding the battery 1, is acquired by a measurement unit 23.

The determination apparatus includes an information acquisition unit 12, a degradation estimation unit 14, an application input unit 15, a determination unit 17, and a storage unit 19.

The information acquisition unit 12 acquires the battery information 21 regarding each battery 1 from the measurement unit 23, and stores the acquired battery information 21 regarding each battery 1 in the storage unit 19 (step #1 in FIG. 3).

The degradation estimation unit 14 estimates the per-cause degradation information 6 for each battery 1 from the battery information 21 regarding the battery 1 stored in the storage unit 19, and stores the per-cause degradation information 6 regarding each battery 1 in the storage unit 19 (step #2 in FIG. 3). The per-cause degradation information 6 is an estimated degradation state per degradation cause 7. That is, the per-cause degradation information 6 regarding each battery 1 is information including degradation states corresponding to respective predetermined degradation causes 7, such as a degradation state corresponding to a degradation cause A (degradation cause 7) and a degradation state corresponding to a degradation cause B (degradation cause 7).

The application input unit 15 is a manual operation tool such as a keyboard or a selection switch, and is configured to receive a manual operation (input) for an application 4 of an electric vehicle 2 and store the application 4 in the storage unit 19 (step #3 in FIG. 3). Note that the application input unit 15 is not limited to receiving a manual operation, and may also be configured to receive the application 4 via communication.

The determination unit 17 ranks the batteries 1 for each application 4 while considering the degree of influence of the degradation cause 7 on the application 4 with the per-cause degradation information 6 (step #4 in FIG. 3). The determination unit 17 then determines a battery 1 corresponding to the input application 4 based on the ranking of the batteries 1 corresponding to the input application 4 (step 5 in FIG. 3). For example, the determination unit 17 sorts batteries 1 that can be used for the input application 4, or selects a battery 1 that is optimal for the input application 4.

[Determination of battery]

Next, as an example of a configuration for determining a battery 1, a configuration will be described with reference to FIGS. 1, 2 and 4 in which a battery 1 is determined using a ranking table 26, which is generated in advance while considering the influence of per-cause degradation information 6 per degradation cause 7 on the applications 4, and is stored in the storage unit 19.

In this embodiment, expected applications 4 of the electric vehicles 2 include normal traveling (application I), traveling in a high-temperature environment (application II), and traveling in which charging (rapid charging) with a high current and traveling are repeated in a low temperature environment (application III).

As the per-cause degradation information 6 regarding the battery 1, a per-cause degradation state 8, which is a degradation state per degradation cause 7, is estimated. In the example of FIG. 4, the estimated degradation causes 7 include degradation due to a growth of a SEI film (resistive film at an electrode-electrolyte interface) (degradation cause A), high-temperature degradation mainly due to gas generation on a positive electrode (degradation cause B), and low-temperature degradation mainly due to a precipitation of lithium metal (degradation cause C).

In the ranking table 26 shown in FIG. 4, a per-cause degradation state $\mu A$ denotes the per-cause degradation state 8 (per-cause degradation information 6) associated with the degradation cause A, a per-cause degradation state $\mu B$ denotes a per-cause degradation state 8 (per-cause degradation information 6) associated with the degradation cause B, and a per-cause degradation state $\mu C$ denotes a per-cause degradation state 8 (per-cause degradation information 6) associated with the degradation cause C. Note that the per-cause degradation state 8 (per-cause degradation information 6) can be a value that decreases from 1 as the degradation progresses. The number of degradation causes 7 is not limited to three, and per-cause degradation states 8 corresponding to any number of degradation causes 7 may be estimated. For example, any combination of the above three causes, an occurrence of cracking in an electrode active material, and crystal phase transition may also be used as the degradation cause 7.

In the ranking table 26, ranking is set in advance in accordance with the application 4, based on the magnitude (condition) of the estimated per-cause degradation state 8 (per-cause degradation information 6) per degradation cause 7.

For example, the condition of a rank "1" regarding the application I is set as "$\mu A < 0.2$ and $\mu B < 0.2$ and $\mu C < 0.2$ and $\mu A + \mu B + \mu C < 0.3$". The rank "1" is the most appropriate (highest) rank for the application 4. For each application 4, the condition of the rank "2" is a condition that the degradation has progressed further than that of the condition of the rank "1", and the condition of rank "3" is that the conditions of the ranks "1" and "2" are not met. The application II is traveling in a high-temperature environment, and the degradation cause B often involves more rapid progress of degradation when the temperature is higher and the degradation has progressed further. Therefore, the condition of the per-cause degradation state $\mu B$ is stricter than the condition for the ranking for the application I. Also, lithium metal reacts with the electrolyte in the battery 1 at high temperatures and generates heat by itself, which in the worst case scenario could lead to a serious accident such as fire. Therefore, in the ranking for the application II, the condition of the per-cause degradation state $\mu C$ is also stricter than the condition for the ranking for the application I. For the application III, the battery 1 is rapidly charged in a low temperature environment, and therefore, the condition of the per-cause degradation state $\mu C$ is stricter in the ranking in view of the possibility of precipitation of lithium metal on a negative electrode. Note that the number of ranks is not limited to three levels, but may be set to any number of levels.

The determination unit 17 first reads from the storage unit 19 the per-cause degradation state 8 per degradation cause 7 estimated by the degradation estimation unit 14 for each battery 1, and the input application 4. The determination unit 17 then compares the per-cause degradation state 8 of each battery 1 with the conditions for the ranking corresponding to the application 4 in the ranking table 26, and determines to which rank the battery 1 corresponds. For example, consider the case that, when a battery 1 is to be selected (determined) for the application 4, i.e., in order to travel in a high temperature environment (application II), the per-cause degradation state $\mu A$ of a certain battery 1 is estimated to be 0.10, the per-cause degradation state $\mu B$ is estimated to be 0.15, and the per-cause degradation state $\mu C$ is estimated to be 0.09. In this case, $\mu A + \mu B + \mu C = 0.34$. Comparing this result with the conditions for the application II in the ranking table 26, the rank of this battery 1 is "2". In this manner, the determination unit 17 identifies the ranks of all the batteries 1 subjected to the determination (selection). Thereafter, an electric vehicle 2 equipped with one of the batteries 1 belonging to the highest rank is selected as the electric vehicle 2 to be used for the application 4, based on the ranking of the batteries 1.

If the per-cause degradation state 8 (per-cause degradation information 6) for the battery 1 and the application 4 are known, the suitability of each battery 1 for use in the application 4 can be determined. Therefore, the ranking indicating the suitability of the batteries 1 for each application 4 can be made using the ranking table 26 under the conditions of the respective per-cause degradation states 8. Accordingly, the rank of each battery 1 can be determined easily and accurately from the per-cause degradation state 8 and the application 4 by using the ranking table 26.

[Degradation estimation]

The per-cause degradation state 8 (degradation state) refers to a certain degradation state that may cause a decrease in the capacity, an increase in the internal resistance, or the like, and can be acquired and calculated using any method. A method of estimating the per-cause degradation state 8 (degradation state) will be described below with reference to FIG. 2.

For example, the degradation of the battery 1 can be approximated by the power law for the time (elapsed time) from the start of its use. That is, the degradation of the battery 1 has a time dependence proportional to the power law of time, and depends on a degradation rate 9, which is the rate of progress of the degradation per degradation cause 7. This proportional relationship can be expressed with a degradation rate coefficient as a constant and a time coefficient as a power exponent. The degradation rate 9 can be estimated from the application 4 for each degradation cause 7. Here, the degradation rate coefficient is a coefficient that depends on various use conditions (applications 4), such as a use environment, a use method, and a use mode, and the time coefficient is a coefficient indicating the time dependence of the degradation state.

Specifically, the per-cause degradation state 8 of the battery 1 can be calculated based on prior per-cause degradation state 28, which is acquired in advance, and a unit per-cause degradation state, which is a degradation state between when the prior per-cause degradation state 28 is calculated (measured) and when a first time period elapses after the calculation. That is, the current per-cause degradation state 8 of the battery 1 can be calculated based on the prior per-cause degradation state 28 acquired at the first time period before the present time and the unit per-cause degradation state during the first time period.

In this case, the per-cause degradation state 8 at the present time (at the time of estimation) has a proportional relationship with a time coefficient as a power exponent. Thus, the per-cause degradation state 8 is calculated based on the prior per-cause degradation state 28 and the unit per-cause degradation state, considering the time dependency according to the power law for the elapsed time. That is, the per-cause degradation state 8 is calculated based on the prior per-cause degradation state 28 and the unit per-cause degradation state indicating the degradation during the first time period, while considering the time dependence that varies depending on the degradation cause 7 and follows the power law for the elapsed time of the per-cause degradation state 8, and the degradation rate 9 that varies depending on the degradation cause 7 and is determined by the use condition (application 4) at the time of calculation (estimation). For example, the per-cause degradation state 8 at the present time (at the time of estimation) can be calculated using a function represented as:

$$\mu t = \{\mu(t-\delta)^{1/\beta} - \alpha^{1/\beta}\cdot\delta\}^{\beta} \ ... \qquad \text{(Equation 1)},$$

where t denotes the time of estimation, $\delta$ denotes the first time period, $\mu t$ denotes the per-cause degradation state 8 at the time t, $\mu(t-\delta)$ denotes the prior per-cause degradation state 28, $\alpha$ denotes the degradation rate coefficient, and $\beta$ denotes the time coefficient.

As described above, the degradation estimation unit 14 can calculate (estimate) the per-cause degradation state 8 using the prior per-cause degradation state 28, and therefore can calculate the per-cause degradation state 8 of the battery 1 accurately. In particular, the prior per-cause degradation state 28 can be an actual measurement value or a predicted correction value that is corrected by taking the actual measurement value into account. In this case, substantial prediction is reduced, i.e., performed only for the degradation state during the first time period, and therefore the per-cause degradation state 8 of the battery 1 can be calculated more accurately.

[Other Embodiments]

(1)In the above embodiment, the degradation of the battery 1 due to use can be estimated not only from the per-cause degradation state 8 but also from the degradation rate 9 per degradation cause 7. Thus, the per-cause degradation information 6 may also include at least either the per-cause degradation state 8 or the degradation rate 9.

The information acquisition unit 12 acquires various types of battery information 21. The per-cause degradation information 6 that can be estimated may differ depending on the acquired battery information 21. Accordingly, there are cases where the degradation estimation unit 14 can estimate the degradation rate 9 per degradation cause 7 even if it is difficult to estimate the per-cause degradation state 8 as the per-cause degradation information 6 based on the acquired battery information 21. The determination of the battery 1 can then be performed based on the estimated per-cause degradation information 6. Thus, the per-cause degradation information 6 can be estimated more flexibly, so that it is possible to determine the degradation state of the battery 1 easily and flexibly, and to accurately determine a battery 1 suitable for the application 4. When both the per-cause degradation state 8 and the degradation rate 9 are used in the determination, the degradation state of the battery 1 can be estimated more accurately, and therefore a battery 1 suitable for the application 4 can be determined accurately.

(2) When the conditions in the aforementioned ranking table 26 are set based on the degradation rate 9, the conditions for each rank may use, as the per-cause degradation information 6, a per-cause degradation state change amount 29, which is the amount of change in the degradation state per unit time that can be obtained based on the degradation rate 9 for each degradation cause 7. The degradation estimation unit 14 estimates the per-cause degradation state change amount 29 per degradation cause 7 for each battery 1, based on the battery information 21 regarding the battery 1. In the ranking table 26, similar to the above-described ranking table 26 based on the per-cause degradation state 8, the ranking for the application 4 is set in advance based on the magnitude (conditions) of the estimated per-cause degradation state change amount 29 (per-cause degradation information 6) per degradation cause 7.

This allows the degradation state of the battery 1 to be estimated more accurately based on the degradation rate 9, and a battery 1 suitable for the application 4 can be determined accurately.

The conditions in the ranking table 26 may also be defined based on the per-cause degradation state 8 and the degradation rate 9 (per-cause degradation state change amount 29).

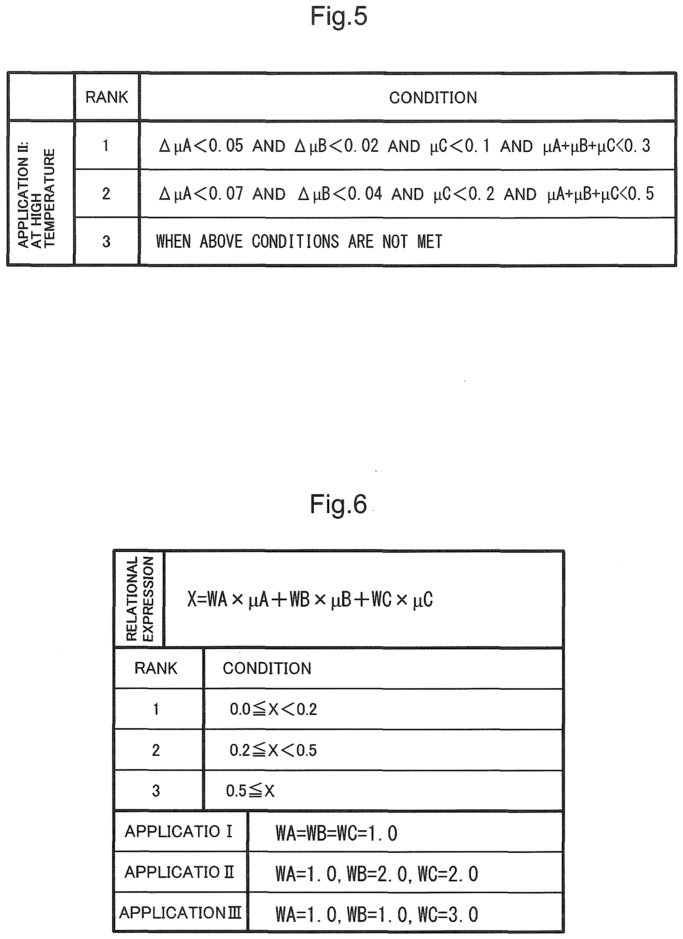

For example, when used at high temperatures, SEI film growth (degradation cause A) and gas generation on the positive electrode (degradation cause B), or the like, are likely to progress. Meanwhile, as for the precipitation of lithium metal (degradation cause C), there is a concern that lithium metal has already precipitated and will react (generate heat by itself) at high temperatures. Therefore, as shown in FIG. 5, the conditions corresponding to SEI film growth (degradation cause A) and gas generation on the positive electrode (degradation cause B) may be defined with emphasis on the degradation rate 9 (per-cause degradation state change amount 29), while the conditions corresponding to lithium metal deposition (degradation cause C) may be defined based on the per-cause degradation state 8. This allows the battery 1 suitable for the application 4 to be determined more accurately.

Note that, in FIG. 5, a per-cause degradation state change amount $\Delta\mu A$ denotes the per-cause degradation state change amount 29 associated with the degradation cause A, a per-cause degradation state change amount $\Delta\mu B$ denotes the per-cause degradation state change amount 29 associated with the degradation cause B, a per-cause degradation state $\mu A$ denotes the per-cause degradation state 8 associated with the degradation cause A, a per-cause degradation state $\mu B$ denotes the per-cause degradation state 8 associated with the degradation cause B, and a per-cause degradation state $\mu C$ denotes the per-cause degradation state 8 for the degradation cause C. FIG. 5 only shows the conditions for the ranking associated with one application 4.

(3) In the above embodiments, the ranking table 26 may use, as the conditions, values obtained by adding weights determined in accordance with the degradation cause 7 to the per-cause degradation information 6. This allows the degradation state of the battery 1 to be estimated more accurately, and therefore a battery 1 suitable for the application 4 can be determined accurately.

(4) In the above embodiments, the determination unit 17 may not only determine the degradation state of the battery 1 by referring to the ranking table 26, but may also determine a battery 1 suitable for the application 4 from a plurality of batteries 1 by any method while considering the degree of influence of the degradation cause 7 on the application 4.

For example, the determination unit 17 determines the rank of each battery 1 from the per-cause degradation information 6 regarding the battery 1 estimated for each degradation cause 7 by the degradation estimation unit 14 based on a determination condition 31. The determination condition 31 is set by a relational expression (condition) conditioned based on the per-cause degradation information 6 per degradation cause 7, and a numerical range corresponding to the rank of a value derived from the relational expression, in correspondence with the application 4. The determination condition 31 is predetermined and stored in the storage unit 19. The per-cause degradation information 6 is at least either the per-cause degradation state 8 or the degradation rate 9, as mentioned above. The relational expression is, for example, the sum of the per-cause degradation information 6 per degradation cause 7.

Furthermore, the determination condition 31 may also be set as a condition obtained by applying a weight (weighting coefficient) determined in accordance with the degradation cause 7 to the relational expression. That is, with the determination condition 31, the relationship between the respective degradation causes 7 and values obtained by applying a weight determined in accordance with the degradation cause 7 to the per-cause degradation information 6 is conditioned, and the batteries 1 are ranked for each condition. This allows a battery 1 suitable for the application 4 to be determined more easily and accurately.

For example, as shown in FIG. 6, the relational expression is represented as:

$$X = WA \times \mu A + WB \times \mu B + WC \times \mu C \quad ... \quad \text{(Equation 2)}$$

where the per-cause degradation state $\mu A$ denotes the per-cause degradation state 8 (per-cause degradation information 6) associated with the degradation cause A, the per-cause degradation state $\mu B$ denotes the per-cause degradation state 8 (per-cause degradation information 6) associated with the degradation cause B, the per-cause degradation state $\mu C$ denotes the per-cause degradation state 8 (per-cause degradation information 6) associated with the degradation cause C, WA denotes a weighting coefficient associated with the degradation cause A, WB denotes a weighting coefficient associated with the degradation cause B, WC denotes a weighting coefficient associated with the degradation cause C, and X denotes the relational expression.

Then, a weighting coefficient is set for each application 4. For example, the weighting coefficient for (application I) is set as WA = WB = WC = 1.0, the weighting coefficient for (application II) is set as WA = 1.0, WB = 2.0, and WC = 2.0, and the weighting coefficient for (application III) is set as WA = 1.0, WB = 1.0, and WC = 3.0. The weighting coefficients are thus set in accordance with the application 4, and the batteries 1 can be ranked simply by substituting a weighting coefficient into the relational expression, thereby allowing the battery 1 suitable for the application 4 to be easily determined with a simple configuration compared with the case where the batteries 1 are ranked using the ranking table 26 or the like.

Also, the numerical range corresponding to the rank "1" is set as $0.0 \le X < 0.2$, the numerical range corresponding to the rank "2" is set as $0.2 \le X < 0.5$, and the numerical range corresponding to the rank "3" is set as $0.5 \le X$.

The determination unit 17 first reads from the storage unit 19 the per-cause degradation state 8 per degradation cause 7 estimated by the degradation estimation unit 14 for each battery 1, and the input application 4. Next, the determination unit 17 determines a weighting coefficient corresponding to the application 4. Next, the determination unit 17 obtains the value of X by substituting the per-cause degradation state 8 of each battery 1 and the weighting coefficient into the relational expression. The determination unit 17 then determines which numerical range the value of X belongs to, and ranks each battery 1. Thereafter, the battery 1 (electric vehicle 2) to be used for the application 4 is selected based on the rank of each battery 1.

(5) In the above-described another embodiment (4), similar to another embodiment (2), the per-cause degradation state change amount 29 (degradation rate 9) may also be considered. In this case, the relational expression is set while considering the per-cause degradation state change amount 29 per degradation cause 7 in addition to the per-cause degradation state 8 per degradation cause 7.

For example, the relational expression under the determination condition 31 is represented as:

$$X = WA1 \times \mu A + WA2 \times \Delta\mu A + WB1 \times \mu B + WB2 \times \Delta\mu B + WC1 \times \mu C + WC2 \times \Delta\mu C \quad \text{(Equation 3)}$$

where the per-cause degradation state change amount $\Delta\mu A$ denotes the per-cause degradation state change amount 29 associated with the degradation cause A, the per-cause degradation state change amount $\Delta\mu B$ denotes the per-cause degradation state change amount 29 associated with the degradation cause B, the per-cause degradation state change amount $\Delta\mu C$ denotes the per-cause degradation state change amount 29 associated with the degradation cause C, WA1 denotes a weighting coefficient of the per-cause degradation state 8 associated with the degradation cause A, WB1 denotes a weighting coefficient of the per-cause degradation state 8 associated with the degradation cause B,

WC1 denotes a weighting coefficient of the per-cause degradation state 8 associated with the degradation cause C, WA2 denotes a weighting coefficient of the per-cause degradation state change amount 29 associated with the degradation cause A, WB2 denotes a weighting coefficient of the per-cause degradation state change amount 29 associated with the degradation cause B, WC2 denotes a weighting coefficient of the per-cause degradation state change amount 29 associated with the degradation cause C, and X denotes the relational expression.

With the determination condition 31, the weighting coefficient of the per-cause degradation state 8 and the weighting coefficient of the per-cause degradation state change amount 29 are set for each application 4 in this relational expression, and the conditions for the relational expression for each rank are set.

The determination unit 17 performs determination with respect to each battery 1 based on the determination condition 31 that considers the above per-cause degradation state change amount 29 (degradation rate 9). Thus, a determination is performed on each battery 1 while considering the degradation rate 9 in addition to the degradation state (per-cause degradation state 8), so that a battery 1 suitable for the application 4 can be determined more accurately.

(6) In the above embodiments, the determination apparatus is not limited to performing determination with respect to the batteries 1 installed the electric vehicles 2, but can also be used to perform determination with respect to batteries 1 for any applications.

Specifically, a battery 1 that has been used for a certain application may become unsuitable for use for that application due to degradation from use. However, there are cases where even such a battery 1 can be reused as a battery 1 for other applications for which the use conditions are not strict. It is possible to determine the possibility of reuse of a battery 1 and the application for which the battery can be reused, based on the current degradation state of the battery 1.

Then, the current degradation state of the battery 1 can be determined by the determination apparatus of the above embodiments. In this case, the determination unit 17 performs determination with respect to each battery 1 using conditions that are ranked in accordance with the application 4 (use condition) for reuse. The battery 1 is reused as a battery 1 for an application different from its previous application in accordance with the result of determination by the determination unit 17.

For example, the batteries 1 installed in the electric vehicles 2 need to be used under stringent conditions since the traveling location and traveling mode are not always constant. Therefore, even if the battery 1 deteriorates to the point where it is no longer suitable as a battery 1 to be installed in an electric vehicle 2 (which corresponds to a first application), it can be reused as a battery 1 to be used while remaining installed at a predetermined location (stationary battery; corresponding to a second application) or as a battery 1 for any other specific use (corresponding to the second application) where the use conditions are relatively stable. Further, if the battery 1 is significantly degraded, it is also conceivable to give up on reuse but recycle the battery 1.

Based on the above, conditions are defined for the ranks corresponding to respective applications 4, namely a stationary battery, a battery 1 for one or more other applications, and recycling. The determination unit 17 performs determination with respect to each battery 1 scheduled to be reused, based on the conditions corresponding to the rank. Then, how to reuse each battery 1 is determined in accordance with the determination result. This makes it possible to determine how to reuse the battery 1 easily.

(7) In the above embodiments, the determination apparatus is not limited to being constituted by functional blocks such as those shown in FIG. 2, but may also be constituted by any functional blocks. For example, each functional block of the determination apparatus may be further subdivided, or conversely, some or all of the functional blocks may be integrated. The functions of the determination apparatus are not limited to the above-described functional blocks, but may also be implemented by a method executed by any functional block. Also, some or all of the functions of the determination apparatus may be constituted by software. A program associated with the software is stored in any storage device such as the storage unit 19, and executed by a processor (computer) such as a CPU included in the determination apparatus, or a separately provided processor (computer). For example, some or all of the procedures of the program may be executed by a processor mounted on a device provided separately from the determination apparatus, such as a server.

Note that the configurations disclosed in the above embodiments (including other embodiments; the same applies below) can be applied in combination with configurations disclosed in other embodiments, as long as no contradiction arises. Furthermore, the embodiments disclosed herein are illustrative. The embodiments of the present invention are not limited thereto, and can be modified as appropriate within the scope that does not deviate from the purpose of the present invention.

Industrial Applicability

The present invention can be applied to a determination apparatus that determines the degradation state of a battery.

Description of Reference Signs

1: Battery
2: Electric vehicle
4: Application
6: Per-cause degradation information
7: Degradation cause
8: Per-cause degradation state
9: Degradation rate
12: Information acquisition unit
14: Degradation estimation unit
15: Application input unit
17: Determination unit
19: Storage unit
21: Battery information
23: Measurement unit
26: Ranking table
28: Prior per-cause degradation state
31: Determination condition

**Claims**

1.  A determination apparatus configured to determine, from a plurality of batteries, a battery suitable for an application, the determination apparatus comprising:

    an information acquisition unit configured to acquire battery information regarding the batteries;
    a degradation estimation unit configured to estimate, for each of the batteries, per-cause degradation information indicating a degradation state per degradation cause from the battery information;
    an application input unit configured to receive an input of the application; and
    a determination unit configured to, based on the estimated per-cause degradation information and the input application, determine a battery suitable for the application from the plurality of batteries while considering a degree of influence of each degradation cause on the application.

2.  The determination apparatus according to claim 1,
    wherein the per-cause degradation information includes at least either a per-cause degradation state that is a degradation state per degradation cause, or a degradation rate that is a progress speed of degradation per degradation cause.

3.  The determination apparatus according to claim 2,
    wherein the per-cause degradation state is calculated based on a prior per-cause degradation state that is the per-cause degradation state at a first time period back, and a unit per-cause degradation state indicating degradation during the first time period, while considering a time dependence that varies depending on the degradation cause and follows a power law for an elapsed time of the per-cause degradation state, and the degradation rate that varies depending on the degradation cause and is determined by the application.

4.  The determination apparatus according to any one of claims 1 to 3, further comprising:

    a storage unit configured to store a ranking table generated for each application,
    wherein in the ranking table, ranking is made in accordance with a value of the per-cause degradation information corresponding to each degradation cause, and
    the determination unit references the ranking table corresponding to the input application, ranks each of the batteries based on the per-cause degradation information estimated for the battery, and determines a battery suitable for the application in accordance with the rank.

5.  The determination apparatus according to any one of claims 1 to 3, further comprising:

    a storage unit configured to store a determination condition generated for each application,
    wherein the determination condition is such that a relationship between each degradation cause and a value obtained by applying a weight determined according to the degradation cause to the per-cause degradation information is defined by a condition, and ranking is made for each condition, and
    the determination unit references the determination condition corresponding to the input application, ranks each of the batteries from the per-cause degradation information estimated for the battery, and determines a battery suitable for the application in accordance with the rank.

6.  The determination apparatus according to any one of claims 1 to 3,

    wherein one of the batteries is installed in each of a plurality of electric vehicles, and
    the electric vehicle in which the battery selected in accordance with a result of determination by the determination unit is installed is selected as the electric vehicle suitable for the application.

7.  The determination apparatus according to any one of claims 1 to 3,
    wherein the battery used for a predetermined first application is reused as the battery to be used for a second application different from the first application in accordance with a result of determination by the determination unit.

8.  A determination method for determining, from a plurality of batteries, a battery suitable for an application, the determination method comprising:

    a step of acquiring battery information regarding the batteries;

a step of estimating, for each of the batteries, per-cause degradation information indicating a degradation state per degradation cause from the battery information;

a step of receiving an input of the application; and

a step of, based on the estimated per-cause degradation information and the input application, determining a battery suitable for the application from the plurality of batteries while considering a degree of influence of each degradation cause on the application.

9. A determination program for determining, from a plurality of batteries, a battery suitable for an application, the determination program causing a computer to execute:

a function of acquiring battery information regarding the batteries;

a function of estimating, for each of the batteries, per-cause degradation information indicating a degradation state per degradation cause from the battery information;

a function of receiving an input of the application; and

a function of, based on the estimated per-cause degradation information and the input application, determining a battery suitable for the application from the plurality of batteries while considering a degree of influence of each degradation cause on the application.

# Fig.1

Fig.2

EP 4 679 115 A1

## Fig.3

```
            ┌──────────────┐
            │    START     │
            └──────┬───────┘
                   │
#1   ┌─────────────▼──────────────┐
     │   ACQUIRE BATTERY          │
     │   INFORMATION              │
     └─────────────┬──────────────┘
                   │
#2   ┌─────────────▼──────────────┐
     │   ESTIMATE PER-CAUSE       │
     │   DEGRADATION INFORMATION  │
     └─────────────┬──────────────┘
                   │
#3   ┌─────────────▼──────────────┐
     │   INPUT APPLICATION        │
     └─────────────┬──────────────┘
                   │
#4   ┌─────────────▼──────────────┐
     │   RANK BATTERY             │
     └─────────────┬──────────────┘
                   │
#5   ┌─────────────▼──────────────┐
     │   PERFORM DETERMINATION    │
     │   WITH RESPECT TO BATTERY  │
     └─────────────┬──────────────┘
                   │
            ┌──────▼───────┐
            │     END      │
            └──────────────┘
```

## Fig.4

| | RANK | CONDITION |
|---|---|---|
| **APPLICATION I: NORMAL TRAVEL** | 1 | $\mu A < 0.2$ AND $\mu B < 0.2$ AND $\mu C < 0.2$ AND $\mu A + \mu B + \mu C < 0.3$ |
| | 2 | $\mu A < 0.4$ AND $\mu B < 0.4$ AND $\mu C < 0.4$ AND $\mu A + \mu B + \mu C < 0.5$ |
| | 3 | WHEN ABOVE CONDITIONS ARE NOT MET |
| **APPLICATION II: AT HIGH TEMPERATURE** | 1 | $\mu A < 0.2$ AND $\mu B < 0.1$ AND $\mu C < 0.1$ AND $\mu A + \mu B + \mu C < 0.3$ |
| | 2 | $\mu A < 0.4$ AND $\mu B < 0.2$ AND $\mu C < 0.2$ AND $\mu A + \mu B + \mu C < 0.5$ |
| | 3 | WHEN ABOVE CONDITIONS ARE NOT MET |
| **APPLICATION III: AT LOW TEMPERATURE, LARGE CHARGING CURRENT** | 1 | $\mu A < 0.2$ AND $\mu B < 0.2$ AND $\mu C < 0.05$ AND $\mu A + \mu B + \mu C < 0.3$ |
| | 2 | $\mu A < 0.4$ AND $\mu B < 0.4$ AND $\mu C < 0.1$ AND $\mu A + \mu B + \mu C < 0.5$ |
| | 3 | WHEN ABOVE CONDITIONS ARE NOT MET |

## Fig.5

| | RANK | CONDITION |
|---|---|---|
| APPLICATION II: AT HIGH TEMPERATURE | 1 | $\Delta\mu A < 0.05$ AND $\Delta\mu B < 0.02$ AND $\mu C < 0.1$ AND $\mu A + \mu B + \mu C < 0.3$ |
| | 2 | $\Delta\mu A < 0.07$ AND $\Delta\mu B < 0.04$ AND $\mu C < 0.2$ AND $\mu A + \mu B + \mu C < 0.5$ |
| | 3 | WHEN ABOVE CONDITIONS ARE NOT MET |

## Fig.6

| RELATIONAL EXPRESSION | $X = WA \times \mu A + WB \times \mu B + WC \times \mu C$ | |
|---|---|---|
| RANK | CONDITION | |
| 1 | $0.0 \leqq X < 0.2$ | |
| 2 | $0.2 \leqq X < 0.5$ | |
| 3 | $0.5 \leqq X$ | |
| APPLICATIO I | $WA = WB = WC = 1.0$ | |
| APPLICATIO II | $WA = 1.0, WB = 2.0, WC = 2.0$ | |
| APPLICATION III | $WA = 1.0, WB = 1.0, WC = 3.0$ | |

## INTERNATIONAL SEARCH REPORT

| International application No. |
|---|
| **PCT/JP2024/008073** |

| A. | CLASSIFICATION OF SUBJECT MATTER |
|---|---|

*G01R 31/392*(2019.01)i; *G01R 31/367*(2019.01)i; *H01M 10/48*(2006.01)i; *H02J 7/00*(2006.01)i
FI:   G01R31/392; G01R31/367; H01M10/48 P; H02J7/00 P; H02J7/00 Y

According to International Patent Classification (IPC) or to both national classification and IPC

| B. | FIELDS SEARCHED |
|---|---|

Minimum documentation searched (classification system followed by classification symbols)

G01R31/392; G01R31/367; H01M10/48; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2022-0120870 A (PMGROW CORPORATION) 31 August 2022 (2022-08-31) paragraphs [0023]-[0055], fig. 1-8 | 1-2, 6-9 |
| A | | 3-5 |
| Y | WO 2021/192844 A1 (HONDA MOTOR CO., LTD.) 30 September 2021 (2021-09-30) paragraphs [0010]-[0046], fig. 1-7 | 1-2, 6-9 |
| A | WO 2021/152826 A1 (TOYO SYSTEM CO., LTD.) 05 August 2021 (2021-08-05) paragraphs [0085]-[0091], fig. 1-4 | 4-5 |
| A | JP 2021-148585 A (GS YUASA INTERNATIONAL LTD.) 27 September 2021 (2021-09-27) entire text, all drawings | 1-9 |
| A | JP 2022-162585 A (TOYOTA JIDOSHA KABUSHIKI KAISHA) 25 October 2022 (2022-10-25) entire text, all drawings | 1-9 |

| ✓ Further documents are listed in the continuation of Box C. | ✓ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 April 2024** | **23 April 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
| --- |
| **PCT/JP2024/008073** |

**C.    DOCUMENTS CONSIDERED TO BE RELEVANT**

| Category* | Citation of document, with indication, where appropriate, of the relevant passages | Relevant to claim No. |
| --- | --- | --- |
| A | KR 10-2022-0112650 A (GREENBASE) 11 August 2022 (2022-08-11)<br>entire text, all drawings | 1-9 |
| A | KR 10-1944751 B1 (MINTECH CO., LTD.) 01 February 2019 (2019-02-01)<br>entire text, all drawings | 1-9 |

Form PCT/ISA/210 (second sheet) (July 2022)

**INTERNATIONAL SEARCH REPORT**
Information on patent family members

International application No.

**PCT/JP2024/008073**

| Patent document cited in search report | | | Publication date (day/month/year) | Patent family member(s) | | | Publication date (day/month/year) |
|---|---|---|---|---|---|---|---|
| KR | 10-2022-0120870 | A | 31 August 2022 | US | 2023/0393206 | A1 | |
| | | | | WO | 2022/181863 | A1 | |
| | | | | EP | 4300108 | A1 | |
| WO | 2021/192844 | A1 | 30 September 2021 | US | 2022/0382771 | A1 | |
| | | | | paragraphs [0017]-[0060], fig. 1-7 | | | |
| | | | | CN | 115104211 | A | |
| WO | 2021/152826 | A1 | 05 August 2021 | US | 2022/0358551 | A1 | |
| | | | | paragraphs [0100]-[0107], fig. 1-4 | | | |
| | | | | EP | 3937291 | A1 | |
| | | | | CN | 113812029 | A | |
| | | | | CA | 3137522 | A1 | |
| | | | | KR | 10-2022-0001514 | A | |
| JP | 2021-148585 | A | 27 September 2021 | US | 2021/0293892 | A1 | |
| | | | | entire text, all drawings | | | |
| JP | 2022-162585 | A | 25 October 2022 | (Family: none) | | | |
| KR | 10-2022-0112650 | A | 11 August 2022 | (Family: none) | | | |
| KR | 10-1944751 | B1 | 01 February 2019 | US | 2020/0249280 | A1 | |
| | | | | WO | 2019/050279 | A1 | |
| | | | | EP | 3680675 | A1 | |

Form PCT/ISA/210 (patent family annex) (July 2022)

**EP 4 679 115 A1**

**Patent documents cited in the description**

- JP 2010181986 A